# EUROPEAN PATENT APPLICATION

(11) **EP 1 307 077 A1**
(43) Date of publication of application: **02.05.2003**
(21) Application number: 01938583.0
(22) Date of filing: 11.06.2001
(51) Int. Cl.: H05K 3/46, H05K 3/38

(54) **ADHESIVE FILM AND METHOD FOR MANUFACTURING MULTILAYER PRINTED WIRING BOARD COMPRISING THE SAME**

(30) Priority: 15.06.2000 JP 2000179882
(71) Applicant: Ajinomoto Co., Inc., Tokyo 104-8315 (JP)
(72) Inventor: NAKAMURA, Shigeo, c/o Aminoscience Laboratories, Kawasaki-shi, Kanagawa 210-8681 (JP); YOKOTA, Tadahiko, c/o Aminoscience Laboratories, Kawasaki-shi, Kanagawa 210-8681 (JP)
(74) Representative: Nicholls, Kathryn Margaret
(86) International application number: JP0104899
(87) International publication number: WO01097582

(57) **Abstract**

In this application is disclosed an adhesive film for a multilayer printed wiring board which comprises at least the following Layer A and Layer B in the adjacent position, wherein the thermosetting resin composition constituting the Layer B is a thermosetting resin composition which contains a resin having a lower softening point than the lamination temperature concerned in an amount of not smaller than 10% by weight, and can fill with itself (or resin-fill) the through holes and/or via holes concurrently with being laminated onto a circuit board;
Layer A: A heat-resistant resin layer comprising at least one heat-resistant resin selected from the group consisting of a polyimide, a liquid crystal polymer, an aramid resin and a polyphenylene sulfide and having a thickness of 2 to 30 µm,
Layer B: A thermosetting resin composition layer which contains an epoxy resin having at least two epoxy groups in one molecule (Component (a)) and an epoxy curing agent (Component (b)) and is solid at ordinary temperature, with the use of which adhesive film can allows an easy introduction of an insulating layer having excellent mechanical strength at the time of producing a multilayer printed wiring board by a build-up technique, and a multilayer printed wiring board having excellent mechanical strength can, in turn, be provided.

## Description

### (Technical Field)

The present invention relates to an adhesive film for incorporating insulating layer(s) into a build-up-type multilayer printed wiring board wherein conductive layer(s) having a circuit formed thereon and insulating layer(s) are alternately stacked.

### (Background Art)

In recent years, attention has been paid to a technique for producing a multilayer printed wiring board based on a build-up method comprising stacking conductive layer (s) having a circuit formed thereon and insulating layer(s) alternately. As a method of forming an insulating layer in producing a multilayer printed wiring board by the build-up method, there has been reported a method in which a resin composition is laminated on a circuit board by means of vacuum lamination using an adhesive film having a specific resin composition layer, as disclosed in, for example, Japanese Patent Application Laid-Open (Kokai) No. 87927/'99.

Meanwhile, it is conceivable that decrease in size and improvement in performance of electronic equipments such as portable telephones will still continue in the future, and that along with the increase in size and the improvement in performance, a further decrease in thickness of the multilayer printed wiring board will be also demanded. In that case, such a multilayer printed wiring board must be made thinner while the mechanical strength of the multilayer printed wiring board needs maintaining. A conventional prepreg or the like which is made of a glass cloth impregnated with an epoxy resin which is used in a prior-art circuit board is excellent in mechanical strength but is limited in a decrease in thickness. Further, sufficient mechanical strength cannot be obtained with the use of only such an adhesive film for forming an insulating layer as disclosed in Japanese Patent Application Laid-Open (Kokai) No. 87927/'99. On the other hand, although there has been also known a method of producing a multilayer printed wiring board with the use of copper foil with a heat-resistant resin such as a thermoplastic polyimide or the like, the glass transition point of such heat resistant resin is so high that a temperature required for lamination becomes high, thereby making it difficult to use the method for general multilayer printed wiring boards.

### (Disclosure of the Invention)

### [Problems to be Solved by the Invention]

It is an object of the present invention to provide an adhesive film which can easily introduce an insulating layer having an excellent mechanical strength at the time of producing a multilayer printed wiring board by a build-up technique. It is another object of the present invention to provide a method for producing easily a multilayer printed wiring board having an excellent mechanical strength.

### [Means for Solving the Problems]

The present inventors have made intensive studies so as to solve the above problems. As a result, they have found that with the use of an adhesive film having a layer of a specific heat-resistant resin and a layer of a specific thermosetting resin composition, an insulating layer having an excellent mechanical strength can be introduced easily in producing a multilayer printed wiring board, and a multilayer printed wiring board having an excellent mechanical strength can be obtained easily. The present invention has been completed based on these findings.

Accordingly, the present invention includes the following aspects.
(1) An adhesive film for a multilayer printed wiring board which comprises at least the following Layer A and Layer B in the adjacent position, wherein the thermosetting resin composition constituting the Layer B is a thermosetting resin composition which contains a resin having a lower softening point than the lamination temperature concerned in an amount of not smaller than 10% by weight, and can fill with itself (or resin-fill) the through holes and/or via holes concurrently with being laminated onto a circuit board.
   Layer A: A heat-resistant resin layer comprising at least one heat-resistant resin selected from the group consisting of a polyimide, a liquid crystal polymer, an aramid resin and a polyphenylene sulfide and having a thickness of 2 to 30 µm.
   Layer B: A thermosetting resin composition layer which contains an epoxy resin having at least two epoxy groups in one molecule (Component (a)) and an epoxy curing agent (Component (b)) and is solid at ordinary temperature.
(2) The adhesive film for a multilayer printed wiring board according to the above aspect (1), wherein the said thermosetting resin composition constituting the Layer B is a thermosetting resin composition which contains a resin having a lower softening point than the lamination temperature concerned in an amount of not smaller than 10% by weight, and can resin-fill the through holes and/or via holes concurrently with being laminated onto a circuit board under the lamination conditions of a temperature of 70 to 140°C, a pressure of 1 to 20 kgf/cm² and an air pressure of not higher than 20 mmHg.
(3) The adhesive film for a multilayer printed wiring board according to the above aspect (1), wherein the said thermosetting resin composition constituting the Layer B is a thermosetting resin composition which further contains, in addition to Components (a) and (b), a polymer compound having a weight average molecular weight of 5, 000 to 100, 000 (Component (c)) in an amount of 5 to 50% by weight, contains a resin having a lower softening point than the lamination temperature concerned in an amount of not smaller than 10% by weight, contains component(s) which is/are liquid at ordinary temperature in an amount of 5 to 55% by weight, and can resin-fill the through holes and/or via holes concurrently with being laminated onto a circuit board.
(4) The adhesive film for a multilayer printed wiring board according to the above aspect (3), wherein the said thermosetting resin composition constituting the Layer B is a thermosetting resin composition which further contains, in addition to Components (a) and (b), a polymer compound having a weight average molecular weight of 5, 000 to 100, 000 (Component (c)) in an amount of 5 to 50% by weight, contains a resin having a lower softening point than the lamination temperature concerned in an amount of not smaller than 10% by weight, contains component(s) which is/are liquid at ordinary temperature in an amount of 5 to 55% by weight, and can resin-fill the through holes and/or via holes concurrently with being laminated onto a circuit board under the lamination conditions of a temperature of 70 to 140°C, a pressure of 1 to 20 kgf/cm² and an air pressure of not higher than 20 mmHg.
(5) The adhesive film for a multilayer printed wiring board according to the above aspect (1), wherein the said thermosetting resin composition constituting the Layer B is a thermosetting resin composition which shows a melt viscosity of 4,000 to 50,000 poises at 90°C, 2,000 to 21,000 poises at 100°C, 900 to 12,000 poises at 110°C, 500 to 9,000 poises at 120°C, and 300 to 15,000 poises at 130°C, when heated with a measurement starting temperature of 60°C and a temperature increasing rate of 5°C/min.
(6) The adhesive film for a multilayer printed wiring board according to any one of the above aspects (1) to (5),
   wherein the said heat-resistant resin layer (Layer A) and the said thermosetting resin composition layer (Layer B) are formed above a removable supporting film layer (Layer C) , in the layer structure in the order of Layer B, Layer A and Layer C, or wherein a heat-resistant resin layer (Layer A) is formed on a removable supporting film layer (Layer C), and a thermosetting resin composition layer (Layer B) is formed on the Layer A.
(7) The adhesive film for a multilayer printed wiring board according to any one of the above aspects (1) to (5),
   wherein the said heat-resistant resin layer (Layer A) and the said thermosetting resin composition layer (Layer B) are formed above a removable supporting film layer (Layer C), in the layer structure in the order of Layer A, Layer B, and Layer C.
(8) The adhesive film for a multilayer printed wiring board according to any one of the above aspects (1) to (5),
   wherein the said heat-resistant resin layer (Layer A) and the said thermosetting resin composition layer (Layer B) are formed above a removable supporting film layer (Layer C) , in the layer structure in the order of Layer B, Layer A, Layer B and Layer C, or wherein a thermosetting resin composition layer (Layer B) is formed on a removable supporting film layer (Layer C), a heat-resistant resin layer (Layer A) is then formed on the formed Layer B, and another thermosetting resin composition layer (Layer B) is then formed on the formed Layer A; and at least the Layer B which is adjacent to the Layer C can be roughened by means of an oxidizing agent.
(9) The adhesive film for a multilayer printed wiring board according to the above aspect (6) or (8), wherein the surface of the said thermosetting resin composition layer (Layer B) which surface is not adjacent to the Layer A is covered with a protective film layer (Layer D) or a removable supporting film layer (Layer C).
(10) A multilayer printed wiring board produced with the use of the adhesive film for a multilayer printed wiring board according to any one of the above aspects (1) to (9).
(11) A method for producing a multilayer printed wiring board, comprising the following steps of (i) to (viii):
   (i) a step of laminating the adhesive film of any one of the aspects (1) to (9) on one or both surfaces of a circuit board with the thermosetting resin composition layer (Layer B) being made to face the circuit board, after a protective film layer (Layer D) or a removable supporting film layer (Layer C) has been removed when the Layer B which is positioned in such that it is in contact with the circuit board upon lamination is covered with the Layer C or D,
   (ii) a step of removing the removable supporting film layer (Layer C) as required when the Layer C is present,
   (iii) a step of thermosetting the thermosetting resin composition layer (Layer B) of the adhesive film laminated on the circuit board so as to form an insulating layer,
   (iv) a step of removing the removable supporting film layer (layer C) when the Layer C is present,
   (v) a step of piercing the circuit board having the insulating layer formed thereon,
   (vi) a step of roughening the surface of the insulating layer,
   (vii) a step of forming a conductive layer on the roughened surface of the insulating layer by plating, and
   (viii) a step of forming a circuit on the conductive layer.

### [Embodiment of the Invention]

Hereinafter, the present invention will be described in greater detail.

An adhesive film for a multilayer printed wiring board of the present invention has, as Layer A, "a heat-resistant resin layer comprising at least one heat-resistant resin selected from the group consisting of a polyimide, a liquid crystal polymer, an aramid resin and a polyphenylene sulfide and having a thickness of 2 to 30 µm" (hereinafter may be abbreviated as "heat-resistant resin layer").

A heat-resistant resin constituting the heat-resistant resin layer comprises at least one of a polyimide, a liquid crystal polymer, an aramid resin or a polyphenylene sulfide. Particularly, the polyimide or the aramid resin is preferred. These resins may be used in combination of two or more thereof. These heat-resistant resins have a glass transition point of not lower than 200°C or a decomposition temperature of not lower than 300°C, and satisfy soldering heat resistance (or heat resistance upon soldering) required in production of a multilayer printed wiring board. When the heat-resistant resin layer has a thickness of smaller than 2 µm, the mechanical strength of an insulating layer or multilayer printed wiring board may not be sufficient, while when the thickness is larger than 30 µm, costs become high, and the insulating layer becomes thicker than necessary, so that micromachining at the time of forming a via hole may become difficult, disadvantageously

As the heat-resistant resins according to the present invention, commercially available ones can be used. For example, heat-resistant resin films such as a polyimide film "UPIREX-S" manufactured by UBE INDUSTRIES, LTD., a polyimide film "Kapton" manufactured by TORAY. DU PONT INDUSTRIES. INC., a polyimide film "APICAL" manufactured by KANEKA CORPORATION, an aramid film "ARAMICA" manufactured by ASAHI KASEI CORPORATION, and a liquid crystal polymer film "Vecstar" manufactured by KURARAY CO., LTD. can be used.

Further, when the adhesive film of the present invention has a removable supporting film layer (Layer C), a heat-resistant resin varnish is applied on the removable supporting film layer (Layer C) directly or after any layer such as a thermosetting resin composition layer (Layer B) has been further formed on the Layer C as required, and the applied varnish is dried so as to form a heat-resistant resin layer (Layer A) in the form of a film. As the heat-resistant resin varnish, there may be used a solvent-soluble polyimide "PI-100 SERIES" manufactured by Maruzen Petrochemical, polyimide varnish "RIKACOAT" SERIES manufactured by NEW JAPAN CHEMICAL CO., LTD., a resin varnish prepared by dissolving a polyimide "ULTEM" manufactured by GE Plastics in an organic solvent, a polyimide silicone manufactured by SHIN-ETSU CHEMICAL CO., LTD., or the like. These heat-resistant resin varnishes can be used as they are or after dissolved in an appropriate organic solvent. Further, these resin varnishes may be used in combination of two or more thereof, and can also be used in admixture of an appropriate thermosetting resin and resin additives. Formation of the heat-resistant resin layer using these heat-resistant resin varnishes can be carried out easily under the same conditions as those under which a thermosetting resin composition layer to be described later is formed.

Insofar as the heat-resistant resin layer (Layer A) according to the present invention is concerned, its surface which makes contact with (or surface adjacent to) the thermosetting resin composition layer (Layer B) according to the present invention has been preferably roughened by chemical roughening treatment, plasma treatment, mechanical polishing or the like in order to increase the strength of adhesion to the Layer B.

The adhesive film of the present invention has, as Layer B, "a thermosetting resin composition layer which contains an epoxy resin having at least two epoxy groups in one molecule (Component (a)) and an epoxy curing agent (Component (b)) and is solid at ordinary temperature" (hereinafter, may be abbreviated as "thermosetting resin composition layer").

Illustrative examples of the "epoxy resin having at least two epoxy groups in one molecule" which is Component (a) include a bisphenol A epoxy resin, a bisphenol F epoxy resin, a phenol novolac epoxy resin, a bisphenol S epoxy resin, an alkyl phenol novolac epoxy resin, a biphenol epoxy resin, a naphthalene epoxy resin, a dicyclopentadiene epoxy resin, an epoxidated condensate of a phenol and an aromatic aldehyde having a phenolic hydroxyl group, triglycidyl isocyanurate, an alicyclic epoxy resin and the like, which have at least two epoxy groups in one molecule. Further, the above epoxy resins after brominated or subjected to the like treatment in order to be provided with flame retardancy, may also be used.

As the epoxy resin which is Component (a), an aromatic epoxy resin having an aromatic ring skeleton in a molecule is preferred. Further, as the epoxy resin which is Component (a) , an epoxy resin which is solid at ordinary temperature or an epoxy resin which is liquid at ordinary temperature may be used. However, a liquid epoxy resin is preferably used.

In this connection, the ordinary temperature according to the present invention may range from 20°C to 30°C.

Illustrative examples of the "epoxy curing agent" which is Component (b) include an amine-based curing agent, a guanidine-based curing agent, an imidazole-based curing agent, a phenol-based curing agent, an acid anhydride-based curing agent, epoxy adducts of these curing agents, encapsulated versions of these curing agents, and the like. Further, these curing agents preferably have a long pot life. The epoxy curing agents can be used in combination of two or more thereof.

Specific examples of the epoxy curing agent include dicyandiamide, 2-phenyl-4-methyl-5-hydroxymethylimidazole, 2-phenyl-4,5-bis(hydroxymethyl)imidazole, 2,4-diamino-6-(2-methyl-1-imidazolylethyl)-1,3,5-triazine·isocyanuric acid adduct, 2,4-diamino-6-(2-undecyl-1-imidazolylethyl)-1,3,5-triazine, and the like.

As the epoxy curing agent, a phenol-based curing agent having a nitrogen atom is particularly preferred, because, when the phenol-based curing agent having a nitrogen atom is used, effects of improving heat resistance, flame retardancy, adhesion, and the like of the insulating layer can be realized. Illustrative examples of such an epoxy curing agent include a triazine-structure-containing novolac resin (e.g., "PHENOLITE 7050" Series, manufactured by Dainippon Ink & Chemicals, Inc.), a melamine-modified phenol novolac resin (e.g., "YLH828", manufactured by Japan Epoxy Resins Co., Ltd.).

Of these epoxy resin curing agents, the amine-based curing agent, the guanidine-based curing agent or the imidazole-based curing agent is generally used in the thermosetting resin composition in an amount of 2 to 12% by weight. In the case of the phenol-based curing agent or the acid anhydride-based curing agent, they are generally used in an amount of 0.5 to 1.3 equivalents in terms of the phenolic hydroxyl group or an acid anhydride per an equivalent of an epoxy group of the epoxy resin contained in the thermosetting resin composition.

Further, in addition to the epoxy curing agent, a curing accelerator can also be added. Illustrative examples of such a curing accelerator include an imidazole-based compound, an organophosphine compound, and the like. When such accelerator is used, it can be used in an amount of preferably 0.5 to 2% by weight based on the epoxy resin contained in the thermosetting resin composition.

The thermosetting resin composition constituting the thermosetting resin composition layer (Layer B) according to the present invention is prepared as a thermosetting resin composition which can fill with itself (or resin-fill) the through holes and/or via holes concurrently with being laminated onto a circuit board. The thermosetting resin composition according to the present invention does not require a vacuum heat press over a long time, and can be laminated easily on a circuit board by means of vacuum lamination. Further, it also has such flowability (resin flowability) that when a circuit board has via holes or through holes, it is softened under lamination conditions and can fill the through holes or via holes present in the circuit board at a time. Through holes which are to be filled with a resin in a multilayer printed wiring board is generally 0.1 to 2 mm, and a thermosetting resin composition which can resin-fill within the range is included in the thermosetting resin composition according to the present invention. For example, when both surfaces of a circuit board are laminated, it is sufficient to have flowability which makes it possible to fill a half of a through hole at the lamination temperature (which generally ranges from 70 to 140°C).

The thermosetting resin composition according to the present invention is capable of laminating a thermosetting resin composition layer on a circuit board by means of vacuum lamination and resin-filling the through holes and/or via holes existing in a circuit board at a time. Therefore, it can easily form an insulating layer on the circuit board. Conditions for the vacuum lamination can generally comprise a temperature of 70 to 140°C, a pressure of 1 to 20 kgf/cm², and an air pressure of not higher than 20 mmHg. Further, the vacuum lamination conditions comprise more preferably a temperature of 80 to 120°C, a pressure of 3 to 10 kgf/cm², and an air pressure of not higher than 10 mmHg.

The thermosetting resin composition according to the present invention contains a resin which has a lower softening point than the lamination temperature concerned in an amount of not lower than 10% by weight. As described above, the lamination temperature can be generally 70 to 140°C. Resin flowability at the time of lamination is not sufficient on condition of under 10% by weight, so that it becomes difficult to fill the resin in through holes or via holes without any voids occurring. The thermosetting resin composition according to the present invention is preferably prepared in such a manner that it contains a resin having a lower softening point than the lamination temperature concerned in an amount of 10 to 90% by weight. Meanwhile, when the content of the resin is higher than 90% by weight, the flowability is liable to be too high, so that it may become difficult to form a uniform insulating layer by vacuum lamination.

The thermosetting resin composition according to the present invention preferably contains a component which is liquid at ordinary temperature in an amount of 5 to 55% by weight. The component which is liquid at ordinary temperature is a component which is contained arbitrarily in the thermosetting resin composition and liquid at ordinary temperature. Such a component is exemplified by resins, organic solvents and the like which are liquid at ordinary temperature.

When the "epoxy resin having at least two epoxy groups in one molecule" which is Component (a) is liquid, it is included in the above resins which are liquid at ordinary temperature. In addition, for example, an epoxy resin which may be contained arbitrarily and has one epoxy group in one molecule is also included in the above resins which are liquid at ordinary temperature. Further, when the aforementioned epoxy curing agent is a resin which is liquid at ordinary temperature, it is also included in the above resins which are liquid at ordinary temperature. Other resins which may be contained arbitrarily and are liquid at ordinary temperature are also included in the above resins which are liquid at ordinary temperature.

As will be described later, an organic solvent is generally used in forming the thermosetting resin composition layer. Illustrative examples of such an organic solvent include ketones such as acetone, methyl ethyl ketone, cyclohexanone, and the like; acetates such as ethyl acetate, butyl acetate, cellosolve acetate, propylene glycol monomethyl ether acetate, carbitol acetate, and the like; carbitols such as cellosolve, butyl carbitol, and the like; aromatic hydrocarbons such as toluene, xylene, and the like; dimethyl formamide; dimethyl acetamide; N-methylpyrrolidone; and the like. These organic solvents may be contained in combination with two or more thereof.

When these organic solvents are contained in the thermosetting resin composition, their content is generally not higher than 10% by weight, preferably not higher than 5% by weight.

When the content of the component which is liquid at ordinary temperature is smaller than 10% by weight, flexibility and sectility (i.e., cutting property) of the adhesive film are not satisfactory, which is not preferable from the viewpoint of handling of the adhesive film. Meanwhile, when the content exceeds 55% by weight, flowability at ordinary temperature is so high that the resin is liable to seep from a cut surface at the time of winding up on a roller in producing the adhesive film, or removability of the adhesive film from a removable supporting film or a protective film is liable to deteriorate.

The thermosetting resin composition according to the present invention preferably further contains in an amount of 5 to 50% by weight, a "polymer compound having a weight average molecular weight of 5,000 to 100,000" which is Component (c) . For example, when the adhesive film for a multilayer printed wiring board of the present invention is to be laminated at a relatively high temperature, flowability of the resin is apt to become too high. However, addition of such polymer compound can facilitate controlling the resin flowability at the time of lamination and preparing a thermosetting resin composition so as to give preferable flowability.

When the weight average molecular weight is lower than 5,000, the effect of controlling the flowability is not satisfactory, while when it is higher than 100,000, solubility of the thermosetting resin composition in an organic solvent may become poor in some cases when the thermosetting resin composition is dissolved in the organic solvent so as to prepare a resin varnish which is to form the thermosetting resin composition layer.

Illustrative examples of the "polymer compound having a weight average molecular weight of 5,000 to 100,000" include a phenoxy resin, a polyacrylic resin, a polyimide resin, a polyamide imide resin, a polycyanate resin, a polyester resin, a thermosetting polyphenylene ether resin, and the like, which have a weight average molecular weight of 5,000 to 100,000.

As the polymer compound, a phenoxy resin is particularly preferred. Illustrative examples of the phenoxy resin include phenoxy resins such as "PHENOTOHTO YP50" (manufactured by Tohto Kasei Co., Inc.), "E-1256" (manufactured by Japan Epoxy Resins Co., Ltd.), and the like, brominated phenoxy resins such as "YPB-40-PXM40" (manufactured by Tohto Kasei Co., Inc.), and the like, a phenoxy resin having a bisphenol S skeleton such as "YL6747H30" (manufactured by Japan Epoxy Resins Co., Ltd.), cyclohexanone varnish of a phenoxy resin composed of a bisphenol-A-type epoxy resin "EPICOAT 828" and bisphenol S (non-volatile component: 30 wt%, and weight average molecular weight: 47,000), and the like.

In a case where the thermosetting resin composition according to the present invention contains a scrubbing component, when the surface of an insulating layer which has been formed after the adhesive film of the present invention is laminated on a circuit board and then heated to be cured, is chemically treated with an oxidizing agent so as to roughen the surface, a conductive layer having an excellent peel strength can be formed easily by plating, on the surface of the insulating layer.

Further, when the thermosetting resin composition according to the present invention contains a phenol-based curing agent as the epoxy curing agent (Component (b)) and a phenoxy resin having a bisphenol S skeleton and a weight average molecular weight of 5,000 to 100,000 as the polymer compound having a weight average molecular weight of 5,000 to 100,000 (Component (c)), the surface of the insulating layer can still be roughened without any scrubbing component.

Illustrative examples of the scrubbing component include a rubber component, an amino resin, an inorganic filler, an organic filler, and the like.

Illustrative examples of the rubber component include polybutadiene rubber, epoxy-modified polybutadiene rubber, urethane-modified polybutadiene rubber, acrylonitrile-modified polybutadiene rubber, methacrylonitrile-modified polybutadiene rubber, acrylonitrile butadiene rubber having carboxyl group(s), methacrylonitrile·butadiene rubber having carboxyl group(s), an acrylic-rubber-dispersed epoxy resin, and the like.

Illustrative examples of the amino resin include amino resins such as a melamine resin, a guanamine resin, an urea resin, and the like, alkyl etherified versions of these amino resins, and the like.

Illustrative examples of the inorganic filler include calcium carbonate, magnesium carbonate, magnesium oxide, aluminum hydroxide, and the like.

Illustrative examples of the organic filler include a powdery epoxy resin, a crosslinked acrylic polymer, thermoset and pulverized versions of the above amino resins, and the like.

When the thermosetting resin composition according to the present invention contains the scrubbing component, its content is preferably 5 to 40% by weight, more preferably 10 to 30% by weight. When the content is smaller than 5% by weight, a degree of roughening of the surface may be insufficient, while when it is higher than 40% by weight, an insulating property, chemical resistance and heat resistance of the insulating layer after curing are liable to be degraded.

Further, in the thermosetting resin composition (Layer B), inorganic fillers other than the above-mentioned inorganic fillers to be used as the scrubbing component may also be contained to impart various properties to the composition. Illustrative examples of such inorganic fillers used as additives include barium sulfate, barium titanate, silicon oxide powders, amorphous silica, talc, clay, mica powders, and the like. These inorganic fillers other than the scrubbing component can be used in the thermosetting resin composition in an amount of 10 to 80% by weight, as required.

Moreover, the thermosetting resin composition (Layer B) according to the present invention can contain a variety of other resin additives as required or as desired. Illustrative examples of such additives include a thickener, an antifoaming agent, a leveling agent, an adhesion imparting agent, a coloring agent, a flame retardant, an inorganic filler, organic filler, and the like.

The thermosetting resin composition constituting the thermosetting resin composition layer (Layer B) according to the present invention can resin- fill the through holes and/or via holes concurrently with being laminated onto a circuit board. Such a thermosetting resin composition is softened, shows desirable flowability (resin flowability), and can resin-fill the through holes or via holes at a time when these holes are present, under the temperature condition (generally from 70 to 140°C) upon vacuum lamination. Such physical properties can be characterized by a temperature-melt viscosity curve obtained by measurement of the modulus of dynamic viscoelasticity of the thermosetting resin composition.

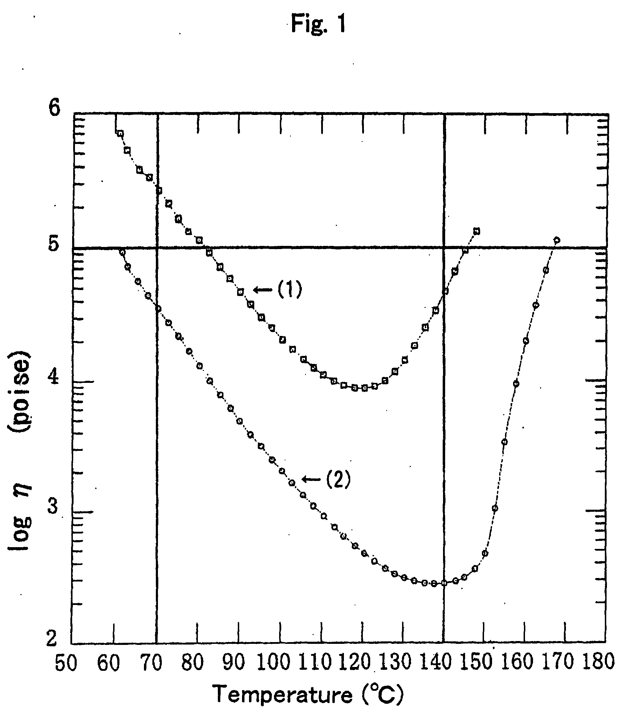

An example of temperature-melt viscosity (η) relationships which have been obtained by measuring the modulus of dynamic viscoelasticity based on the thermosetting resin composition obtained in Example 1 to be described later and are preferable for the thermosetting resin composition according to the present invention, will be shown in Fig. 1. Fig. 1 is a diagram showing curves representing melt viscosities of the thermosetting resin composition when the composition started and continued to be heated at a measurement starting temperature of 60°C and a temperature increasing rate of 5°C/min. Based on the figure, when relationships between temperatures and melt viscosities of thermosetting resin compositions are measured under the same conditions, those whose melt viscosities corresponding to the temperatures fall within the range shown in the following Table 1, more preferably within the range shown in Table 2, can be considered as preferable thermosetting resin compositions according to the present invention.

**Table 1**

| Temperature (C°) | Melt Viscosity (poise) |
|---|---|
| 90 | 4,000∼50,000 |
| 100 | 1,000∼21,000 |
| 110 | 900∼12,000 |
| 120 | 500∼ 9,000 |
| 130 | 300∼15,000 |

**Table 2**

| Temperature (C°) | Melt Viscosity (poise) |
|---|---|
| 90 | 10,000∼25,000 |
| 100 | 5,000∼10,000 |
| 110 | 2,000∼ 6,000 |
| 120 | 1,000∼ 5,000 |
| 130 | 600∼ 3,000 |

It is common practice that the thickness of the thermosetting resin composition layer (Layer B) which makes direct contact with the surface of a circuit board is larger than or equal to the thickness of the conductive layer. While the thickness of the conductive layer of the circuit board is generally 5 to 70 µm, the Layer B preferably has a thickness of 5 to 100 µm plus the range of the thickness of the conductive layer.

As regards a thermosetting resin composition layer (Layer B) which does not contribute to the coating of the conductive layer (or the filling of via holes or through holes), i.e., a thermosetting resin composition layer (Layer B) which is used primarily for forming the conductive layer on the surface after thermoset and can be roughened by an oxidizing agent, the Layer B preferably has a thickness of 2 to 20 µm. For example, when the adhesive film of the present invention has a layer structure of "(1) a thermosetting resin composition layer (Layer B)/(2) a heat-resistant resin layer (Layer A)/(3) a thermosetting resin composition layer which can be roughened with an oxidizing agent (Layer B)", the thermosetting resin composition layer (1) can be used to coat the conductive layer while the thermosetting resin composition layer (3) which can be roughened with an oxidizing agent can be used as the surface of the insulating layer on which the conductive layer is formed by plating after thermoset, upon lamination of the adhesive film on a circuit board.

In such a case, when the thickness of the thermosetting resin composition layer which can be roughened with an oxidizing agent is smaller than 2 µm, desirable uneven or rough surface after the roughening treatment is liable not to be obtained, while when the thickness is larger than 20 µm, the thickness of the insulating layer increases more than necessary, which is not desirable from the viewpoint of attainment of reduction in the thickness of the multilayer printed wiring board.

The thermosetting resin composition layer (Layer B) which does not contribute to the coating of the conductive layer (and the filling of via holes or through holes) does not need to have a specific flowability required for the coating of the conductive layer in vacuum lamination.

As the method for forming the thermosetting resin composition layer (Layer B), there may be mentioned a method wherein a resin varnish is first prepared by dissolving the thermosetting resin composition in such an organic solvent as exemplified above, and then coated on the heat-resistant resin layer (Layer A) or the removable supporting film layer (Layer C) as a substrate, and the organic solvent is then dried or vaporized by heating or hot air drying. Two or more of organic solvents can be used in combination as required.

A removable supporting film according to the present invention is generally used as a substrate when the heat-resistant resin layer is formed from a heat-resistant resin varnish or a substrate when the thermosetting resin composition layer is formed from the resin varnish of the thermosetting resin composition.

When the adhesive film for a multilayer printed wiring board of the present invention has a removable supporting film layer (Layer C), a polyester film such as a polyethylene terephthalate film or the like, a polycarbonate film, removable paper, or the like, can be used as such removable supporting film layer C. As for the thickness of the removable supporting film, a thickness of 10 to 150 µm is generally employed, and a thickness of 25 to 50 µm is preferably employed. The removable supporting film may be in advance subjected to mat treatment, corona treatment, release treatment, or the like.

The removable supporting film according to the present invention is removed after the adhesive film of the present invention is laminated on a circuit board or cured by heating so as to form the insulating layer. When the removable supporting film is removed after the adhesive film is cured by heating, adhesion of dust and the like in the curing step or process can be prevented. When removed after the adhesive film is cured, the removable supporting film is subjected to release treatment in advance.

When s thermosetting resin composition layer is formed on the removable supporting film or heat-resistant resin composition layer, it is preferable to form the thermosetting resin composition layer such that the area of the thermosetting resin composition layer is smaller than that of the removable supporting film.

A protective film in the adhesive film for a multilayer printed wiring board of the present invention is used mainly to protect the thermosetting resin composition layer, e.g., to prevent dust and the like from adhering to the adhesive film, and to prevent the adhesive film from being scratched. Therefore; the protective film is generally removed before the adhesive film is laminated on a circuit board. Further, for example, when the adhesive film is prepared by forming and bonding the thermosetting resin composition layer or heat-resistant resin layer on the removable supporting film, the removable supporting film layer serves the role of the protective film layer in some cases.

When the adhesive film of the present invention has the protective film layer (Layer D), a polyethylene film, a polypropylene film, a polyethylene terephthalate film or the like can be used as the Layer D. As for the thickness of the protective film layer, a thickness of 1 to 40 µm is generally used.

Examples of a preferable layer structure of the adhesive film for a multilayer printed wiring board according to the present invention are as follows.

Layer Structure Example (1) : protective film layer (Layer D) or removable supporting film layer (Layer C)/thermosetting resin composition layer (Layer B)/heat-resistant resin layer (Layer A)/thermosetting resin composition layer which can be roughened with an oxidizing agent (Layer B)/removable supporting film layer (Layer C),

Layer Structure Example (2): Layer D or Layer C/Layer B/Layer A, and

Layer Structure Example (3): Layer D or Layer C/Layer B/Layer A/Layer C.

In Layer Structure Example (1), both of the thermosetting resin composition layers (Layers B) may be ones which can be roughened with an oxidizing agent.

In the case of an adhesive film having a layer structure represented by Layer Structure Example (1), the protective film layer (or the removable supporting film layer) is removed, and the adhesive film is then laminated on a circuit board such that the thermosetting resin composition layer exposed after removal of the layer makes contact at the exposed surface with the circuit board, and then cured by heating so as to form an insulating layer. A removable supporting film layer present at the time of lamination is removed after the lamination or curing of the adhesive film by heating.

The thus formed insulating layer exhibits excellent mechanical strength, interlayer insulating property, dimensional stability at the time of heating, and the like, because it has a heat-resistant resin layer. When a thermosetting resin composition layer which can be roughened with an oxidizing agent (Layer B) is formed on the surface of the insulating layer, the surface of the insulating layer can be roughened easily, and a conductive layer can be formed easily by plating.

Roughening treatment with an oxidizing agent (particularly, alkaline permanganic acid solution) is generally used as means for forming a conductive layer in production of a multilayer printed wiring board by a build-up technique. Therefore, when the adhesive film of the present invention has such a layer structure that the thermosetting resin composition layer positioned on the surface of the insulating layer is a thermosetting resin composition layer which can be roughened with an oxidizing agent, a multilayer printed wiring board can be produced more easily.

Examples of a method for producing the adhesive film having a layer structure represented by Layer Structure Example (1) are as follows.
(1) A resin varnish of a thermosetting resin composition is coated on a heat-resistant resin film and dried, and a protective film is then laminated on the surface of the thermosetting resin composition layer (Film 1: Layer D/Layer B/Layer A). Separately, another resin varnish of a thermosetting resin composition which can be roughened with an oxidizing agent is coated on a removable supporting film and dried (Film 2: Layer B/Layer C) . Then, the Film 2 is laminated on the Film 1 such that the surface of the thermosetting resin composition layer of the Film 2 makes contact with the surface of the heat-resistant resin composition layer of the Film 1 (Layer D/Layer B/Layer A/Layer B which can be roughened with an oxidizing agent/Layer C).
(2) A resin varnish of a thermosetting resin composition which can be roughened with an oxidizing agent is coated on a heat-resistant resin film and dried, and a removable supporting film is then laminated on the surface of the resin composition layer (Film 1: Layer C/Layer B which can be roughened with an oxidizing agent/Layer A). Then, another resin varnish of a thermosetting resin composition is coated on the surface of the Layer A of the Film 1 and dried, and a removable supporting film is further laminated on the surface of the thermosetting resin composition layer (Layer C/Layer B which can be roughened with an oxidizing agent/Layer A/Layer B/Layer C).
(3) A resin varnish of a thermosetting resin composition which can be roughened with an oxidizing agent is coated on a removable supporting film and dried, and a heat-resistant resin varnish is then coated on the thermosetting resin composition layer and dried (Layer A/Layer B which can be roughened with an oxidizing agent/Layer C). Then, another resin varnish of a thermosetting resin composition is coated on the surface of the heat-resistant resin layer and dried, and a protective film is then laminated on the surface of the thermosetting resin composition layer (Layer D/Layer B/Layer A/Layer B which can be roughened with an oxidizing agent/Layer C).
(4) A resin varnish of a thermosetting resin composition which can be roughened with an oxidizing agent is coated on a removable supporting film and dried (Film 1: Layer B which can be roughened with an oxidizing agent/Layer C). Separately, another resin varnish of a thermosetting resin composition is coated on a removable supporting film and dried (Film 2: layer B/Layer C). The Films 1 and 2 are laminated on both surfaces of a heat-resistant resin film such that the surfaces of the thermosetting resin composition layers of the Films 1 and 2 make contact with the surfaces of the heat-resistant resin film, respectively (Layer C/Layer B/Layer A/Layer B which can be roughened with an oxidizing agent/Layer C).

In the case of adhesive films having layer structures represented by Layer Structure Examples (2) and (3), the protective film layer (or the removable supporting film layer) is removed, and the adhesive film is then laminated on a circuit board such that the thermosetting resin composition layer exposed after removal of the layer makes contact at the exposed surface with the circuit board and then cured by heating so as to form an insulating layer. In the case of Layer Structure Example (3), the removable supporting film layer present at the time of lamination is removed after the lamination or curing of the adhesive film by heating. In addition, by roughening the surface of the heat-resistant resin layer positioned on the surface of the insulating layer, a conductive layer can be formed by plating.

The adhesive films having layer structures represented by Layer Structure Examples (2) and (3) can be produced in accordance with the foregoing adhesive film having a layer structure represented by Layer Structure Example (1).

The adhesive film of the present invention can be stored in a rolled form.

As a method of producing multilayer printed wiring boards using the adhesive film of the present invention, there may be mentioned as a typical example, e.g., a method for producing a multilayer printed wiring board, which method comprises the following steps of (i) to (viii) as referred to above:
(i) a step of laminating an adhesive film of the present invention on one or both surfaces of a circuit board with a thermosetting resin composition layer (Layer B) being made to face the circuit board, after a protective film layer (Layer D) or a removable supporting film layer (Layer C) has been removed when the Layer B which is positioned in such that it is in contact with the circuit board upon lamination is covered with the Layer C or D,
(ii) a step of removing the removable supporting film layer (Layer C) as required when the Layer C is present,
(iii) a step of thermosetting the thermosetting resin composition layer (Layer B) of the adhesive film laminated on the circuit board so as to form an insulating layer,
(iv) a step of removing the removable supporting film layer (layer C) when the Layer C is present,
(v) a step of piercing the circuit board having the insulating layer formed thereon,
(vi) a step of roughening the surface of the insulating layer,
(vii) a step of forming a conductive layer on the roughened surface of the insulating layer by plating, and
(viii) a step of forming a circuit on the conductive layer.

In greater details, when the adhesive film for a multilayer printed wiring board of the present invention is laminated on a circuit board, if a thermosetting resin composition layer (Layer B) which makes contact with the circuit board at the time of lamination is protected with a protective film layer (Layer D) or a removable supporting film layer (Layer C), these layers are removed first, and then the adhesive film is laminated on one or both surfaces of the circuit board such that the Layer B makes contact with the circuit board. For the adhesive film of the present invention, a method of laminating the adhesive film on a circuit board by vacuum lamination is suitably used.

The method of the lamination may be a batch method or a continuous method using a roller. Further, the adhesive film and the circuit board may be preheated, as required, prior to the lamination. Conditions for the lamination are as described above.

The vacuum lamination can be carried out by use of a commercially available vacuum laminator. Illustrative examples of the commercially available vacuum laminator include "VACUUM APPLICATOR" manufactured by Nichigo-Morton Co., Ltd., "VACUUM PRESSURE LAMINATOR" manufactured by MEIKI CO., LTD., "ROLL-TYPE DRY COATER" manufactured by HITACHI TECHNOENGINEERING CO., LTD., "VACUUM LAMINATOR" manufactured by HITACHI AIC INC., and the like.

A circuit board according to the present invention is primarily a board such as glass epoxy, a metal board, a polyester board, a polyimide board, a BT resin board, a thermosetting polyphenylene ether board, or the like, which has a conductive layer (circuit) patterned on one or both surfaces thereof. Further, a multilayer printed wiring board formed by laminating a conductive layer and an insulating layer laminated alternately and having a conductive layer (circuit) patterned on one or both of the outermost layers of a multilayer printed wiring board is also included in the circuit board used according to the present invention. The surface of the conductive circuit layer is preferably roughened by blackening treatment, or the black oxide treatment, or the like in advance from the viewpoint of adhesion of the insulating layer onto the circuit board.

When a removable supporting film layer (Layer C) is present, the Layer C may be removed after lamination.

Although conditions for heat-curing vary depending on resins, a cure temperature is generally selected from a range of 100 to 200°C, and a cure time is generally selected from a range of 10 to 90 minutes. Curing with the cure temperature being raised from a relatively low temperature to a high temperature is preferred from the viewpoint of prevention of occurrences of wrinkles on the surface of the insulating layer and voids in holes and the like.

When a removable supporting film layer (Layer C) is present, the Layer C is removed after curing.

Then, the insulating layer formed on the circuit board is pierced as required so as to form via holes and/or through holes. Piercing can be performed by a known method such as a mechanical drill, laser, plasma or the like, or by combining these methods as required.

Then, the surface of the insulating layer is subjected to a roughening treatment. The surface can be roughened by a dry method, a wet method or a combination of these methods.

Illustrative examples of the dry method include roughening treatment by mechanical polishing such as buffing, sandblasting or the like, roughening treatment by plasma etching, or the like.

Illustrative examples of the wet method include roughening treatment with the use of a chemical such as an oxidizing agent solution, e.g., an alkaline permanganic acid solution, a dichromate, ozone, hydrogen peroxide/sulfuric acid, nitric acid, or the like, or a strong alkaline solution.

When the surface to be roughened of the insulating layer is a heat-resistant resin layer, it is preferable to roughen the surface by the dry method from the viewpoint of peel strength or the like of the conductive layer formed by plating. Meanwhile, when the surface to be roughened of the insulating layer is a thermosetting resin composition layer, the thermosetting resin composition layer is preferably a thermosetting resin composition layer which can be roughened by roughening treatment by a wet method using an oxidizing agent. The roughening treatment with an oxidizing agent is generally used as means for forming a conductive layer in production of a multilayer printed wiring board by a build-up technique, and it thereby becomes easier to produce multilayer printed wiring boards.

As the oxidizing agent, an alkaline permanganic acid solution is particularly preferred. Specific examples of the alkaline permanganic acid solution include a sodium hydroxide solution of potassium permanganate or sodium permanganate.

Then, a conductive layer is formed by plating on the roughened surface of the insulating layer. Illustrative examples of a plating method include a dry plating method, a wet plating method, and the like.

As the dry plating method, there may be used a known method such as vapor deposition, sputtering, ion plating, or the like.

As for the wet plating method, firstly, the surface of the resin composition layer (insulating layer) is roughened with an oxidizing agent such as an alkaline permanganic acid solution or the like so as to form protruding and depressed anchors. Then, the conductive layer is formed by a method using electroless plating and electrolytic plating in combination. Alternatively, it is also possible that a plating resist whose pattern is the reverse of the conductive layer is formed and the conductive layer is formed only by electroless plating. After formation of the conductive layer, it can be annealed at 150 to 200°C for 20 to 90 minutes so as to improve and stabilize peel strength of the conductive layer.

Further, as a method of patterning the conductive layer so as to form a circuit, processes known to those skilled in the art, such as a subtractive process, a semiadditive process and the like can be used.

### (Brief Description of the Drawings)

Fig. 1 shows the results of measurement of the moduli of dynamic viscoelasticity indicated by the thermosetting resin composition prepared in Example 1 given below and when treated under two different kinds of drying conditions.
Fig. 2 shows the results of measurement of the moduli of dynamic viscoelasticity indicated by the thermosetting resin composition prepared in the Example 1 and when treated under additional three kinds of drying conditions.
Fig. 3 shows the results of measurement of the moduli of dynamic viscoelasticity indicated by the thermosetting resin composition prepared in the Example 1 and when treated under still additional three kinds of drying conditions.
Fig. 4 shows the results of measurement of the modulus of dynamic viscoelasticity indicated by the thermosetting resin composition layer of the adhesive film prepared in Example 4 given below.

In this connection, η indicates Melt Viscosity in each Figure.

### (Best Mode for Carrying out the Invention)

The present invention will be concretely described below with reference to Examples. However, it is not limited to these

### Examples.

### Example 1

20 parts by weight of liquid bisphenol A-type epoxy resin (epoxy equivalents: 185, "EPICOAT 828 EL" manufactured by Yuka Shell Epoxy K.K.), 20 parts by weight of brominated bisphenol A-type epoxy resin (epoxy equivalents: 500, "YD-500" manufactured by Tohto Kasei Co., Inc.), 20 parts by weight of cresol novolac-type epoxy resin (epoxy equivalents: 215, "EPICRON N-673" manufactured by Dainippon Ink & Chemicals, Inc.), and 15 parts by weight of terminal-epoxidated polybutadiene rubber ("DENAREX R-45 EPT" manufactured by NAGASE KASEI KOUGYO CO., LTD.) were dissolved in methyl ethyl ketone by heating with stirring. Then, to the mixture were added 50 parts by weight of brominated phenoxy resin varnish (non-volatile component; 40 wt%, solvent composition; xylene:methoxypropanol:methyl ethyl ketone = 5:2:8, "YPB-40-PXM40" manufactured by Tohto Kasei Co., Inc.), 4 parts by weight of 2,4-diamino-6-(2-methyl-1-imidazolylethyl)-1,3,5-triazine·isocyanuric acid adduct as an epoxy curing agent, and further, 2 parts by weight of pulverized silica, 4 parts by weight of antimony trioxide, and 5 parts by weight of calcium carbonate, whereby a resin varnish of a thermosetting resin composition was prepared.

The resin varnish was coated on a polyimide film ("UPIREX-S" (thickness: 12.5 µm, glass transition point: 500°C or higher) manufactured by UBE INDUSTRIES, LTD.) both surfaces of which had been subjected to plasma treatment, by means of a die coater such that the thickness of the coated resin would be 60 µm after dried. After the coated resin varnish was dried at 80 to 120°C (100°C on the average) for about 8 minutes (residual solvent: about 2 wt%), the resulting film was wound up in a roll form while a polypropylene film having a thickness of 15 µm was being laminated onto the surface of the dried thermosetting resin composition. The rolled adhesive film was slit to a width of 507 mm, thereby obtaining an adhesive film sheet having a size of 507 × 336 mm. The layer structure of the resulting adhesive film was of polypropylene film layer (protective film layer)/thermosetting resin composition layer/polyimide film layer (heat-resistant resin layer).

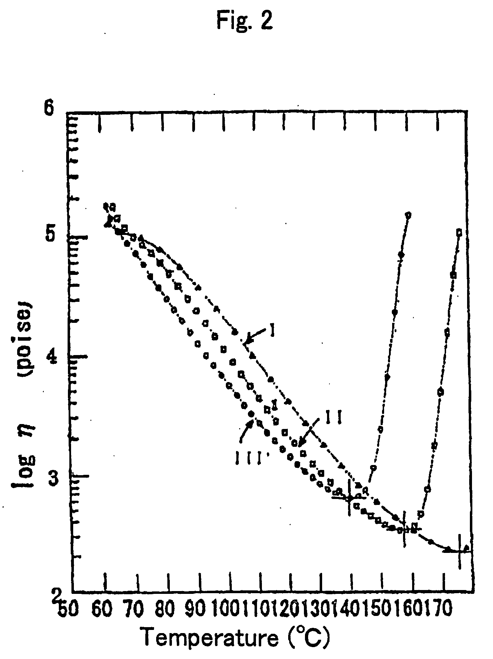

The results of measurements of the moduli of dynamic viscoelasticity of the thus obtained thermosetting resin composition are shown in Figs. 1 and 2. The measurements were made by use of "dynamic viscoelasticity measuring device Rheosol-G3000" manufactured by UBM CO., LTD.

In Fig. 1, the upper curve (1) of the modulus of dynamic viscoelasticity was measured on a thermosetting resin composition layer obtained by coating the resin varnish of the thermosetting resin composition and drying the coated resin varnish by heating at an average drying temperature of 100°C for 10 minutes. Meanwhile, the lower curve (2) of the modulus of dynamic viscoelasticity was measured on a thermosetting resin composition layer obtained by coating the resin varnish of the thermosetting resin composition and treating the coated resin varnish by heating at an average drying temperature of 100°C for 3.5 minutes. The measurements were made at a temperature increasing rate at the time of measurement of 5°C/min, a measurement staring temperature of 60°C, a temperature increase between measurements of 2.5°C, and a frequency of 1 Hz/deg. Some measurements values are shown in the following Table 3.

**Table 3**

| Temperature (C°) | Melt Viscosity (poise) |
|---|---|
| 70 | 35,000∼265,000 |
| 80 | 12,900∼114,500 |
| 90 | 4,900∼ 46,400 |
| 100 | 2,000∼ 20,400 |
| 110 | 900- 11,100 |
| 120 | 470∼ 8,800 |
| 130 | 300∼ 14,200 |
| 140 | 280∼ 46,800 |

Fig. 2 shows curves of the moduli of dynamic viscoelasticity measured on a thermosetting resin composition layer obtained by coating the same resin varnish of the thermosetting resin composition and heating the coated resin varnish at an average drying temperature of 100°C for 5 minutes. The curve I was measured at a temperature increasing rate of 20°C/min, the curve II was measured at a temperature increasing rate of 10°C/min, and the curve III was measured at a temperature increasing rate of 5°C/min. Incidentally, the measurements were made at a measurement staring temperature of 60°C, a temperature increase between measurements of 2.5°C, and a frequency of 1 Hz/deg.

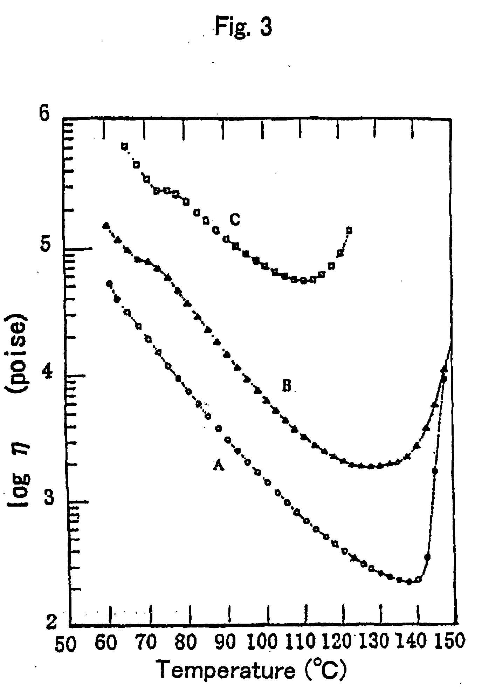

Fig. 3 shows curves of the moduli of dynamic viscoelasticity measured on a thermosetting resin composition layer obtained by coating the same resin varnish of the thermosetting resin composition and drying the coated resin varnish at an average drying temperature of 100°C for certain minutes. The curve A was for 2 minutes (Adhesive film used in Comparative Example 2), the curve B was for 8 minutes (Adhesive film used in Examples 5 and 8), and the curve C was for 15 minutes (Adhesive film used in Comparative Example 3). Further, the measurements were made at a measurement staring temperature of 60°C, a temperature increase between measurements of 2.5°C, and a frequency of 1 Hz/deg. Part of the measurement results will be shown in the following Table 4.

**Table 4**

| Curve A | |
|---|---|
| Temperature (C°) | Melt Viscosity (poise) |
| 70 | 19,300 |
| 80 | 7,500 |
| 90 | 3,100 |
| 100 | 1,400 |
| 110 | 690 |
| 120 | 390 |
| 130 | 260 |
| 140 | 220 |

| Curve B | |
|---|---|
| Temperature (C°) | Melt Viscosity (poise) |
| 70 | 80,000 |
| 80 | 36,000 |
| 90 | 14,600 |
| 100 | 6,300 |
| 110 | 3,200 |
| 120 | 2,100 |
| 130 | 1,900 |
| 140 | 2,700 |

| Curve C | |
|---|---|
| Temperature (C°) | Melt Viscosity (poise) |
| 70 | 348,000 |
| 80 | 234,000 |
| 90 | 121,000 |
| 100 | 72,000 |
| 110 | 54,000 |
| 120 | 92,000 |

### Example 2

On a release-treated surface of a polyethylene terephthalate film having a thickness of 38 µm, a varnish prepared by dissolving "solvent-soluble type polyimide PI-100 (glass transition temperature: 300°C) " manufactured by MARUZEN PETROCHEMICAL in N,N-dimethylformamide, was coated and then dried at 80 to 145°C (120°C on the average) so as to form a polyimide film layer having a thickness of 5 µm.

On the polyimide film layer, the resin varnish of the thermosetting resin composition obtained in Example 1 was coated by means of a die coater such that the thickness of the coated resin would be 40 µm after dried. After the coated resin varnish was dried at 80 to 120°C (100°C on the average) (residual solvent: about 2 wt%), the resulting film was wound up in a roll form while a polypropylene film having a thickness of 15 µm was being laminated onto the surface of the dried thermosetting resin composition. The rolled adhesive film was slit to a width of 507 mm, thereby obtaining an adhesive film sheet having a size of 507 × 336 mm.

The obtained adhesive film had a layer structure in the order of polypropylene film layer (protective film layer)/thermosetting resin composition layer/polyimide film layer (heat-resistant resin layer)/polyethylene terephthalate film (removable supporting film layer).

### Example 3

50 parts by weight of brominated bisphenol A-type epoxy resin ("YDB-500" manufactured by Tohot Kasei Co., Inc.), 20 parts by weight of cresol novolac-type epoxy resin (epoxy equivalents: 215, softening point: 78°C, "EPICRON N-673" manufactured by Dainippon Ink & Chemicals, Inc.), and 15 parts by weight of terminal-epoxidated polybutadiene rubber ("DENAREX R-45 EPT" manufactured by NAGASE KASEI KOUGYO CO., LTD.) were dissolved in a methyl ethyl ketone/toluene mixed solvent by heating with stirring agitation. Then, to the mixture were added 4 parts by weight of 2,4-diamino-6-(2-methyl-1-imidazolyl)-ethyl-1,3,5-triazine as an epoxy curing agent, and additionally, 2 parts by weight of pulverized silica, and 10 parts by weight of calcium carbonate, whereby a resin varnish of a thermosetting resin composition was prepared.

The resin varnish was coated on a polyimide film in the same manner as in Example 1. After the coated resin varnish was dried at 80 to 120°C (100°C on the average) to form a thermosetting resin composition layer having a thickness of 5 µm, a release-treated polyethylene terephthalate film having a thickness of 25 µm was laminated on the thermosetting resin composition layer. Thereafter, a thermosetting resin composition layer having a thickness of 60 µm was formed, in the same manner as in Example 1, on the surface of the polyimide film which was opposite to its surface on which the thermosetting resin composition layer was formed, and the resulting film was wound up in a roll form while a release-treated polyethylene terephthalate film having a thickness of 38 µm was being laminated onto the surface of the dried thermosetting resin composition. The rolled adhesive film was slit to a width of 507 mm, thereby obtaining an adhesive film sheet having a size of 507 × 336 mm.

The obtained adhesive film had a layer structure in the order of polyethylene terephthalate film (removable supporting film layer)/thermosetting resin composition layer which can be roughened with an oxidizing agent/polyimide film layer (heat-resistant resin layer)/thermosetting resin composition layer/polyethylene terephthalate film (removable supporting film layer).

### Example 4

20 parts by weight of bisphenol A-type epoxy resin ("EPICOAT 828" manufactured by Yuka Shell Epoxy Co., K.K.) and 35 parts by weight of cresol novolac-type epoxy resin (epoxy equivalents: 215, softening point: 78°C, "EPICRON N-673" manufactured by Dainippon Ink & Chemicals, Inc.) were dissolved in MEK by heating with stirring, and the mixture was cooled to ordinary temperature. Then, to the mixture were added 45 parts by weight of MEK varnish of a triazine structure-containing phenol novolac resin ("PHENOLITE LA-7052" manufactured by Dainippon Ink & Chemicals, Inc., non-volatile component: 60%, phenolic hydroxyl group equivalents of the non-volatile component: 120), 70 parts by weight of a cyclohexanone varnish of a phenoxy resin ("YL6746H30" manufactured by Yuka Shell Epoxy K.K., non-volatile component: 30 wt%, weight average molecular weight: 30,000) comprising tetramethyl-type biphenol-type epoxy resin ("YX-4000" manufactured by Yuka-Shell Epoxy Co., Ltd.) and bisphenol S, and additionally, 18 parts by weight of spherical silica, and 2 parts by weight of pulverized silica, whereby an epoxy resin composition was prepared.

The epoxy resin composition varnish was coated on a release-treated surface of a polyethylene terephthalate film having a thickness of 38 µm and then dried at 80 to 120°C (100°C on the average) (amount of the residual solvent: about 2 wt%), a thermosetting resin composition layer having a thickness of 10 µm or 45 µm was formed, and the resulting films having the thermosetting resin composition layers of two different film thicknesses were wound up in roll forms, respectively. Then, a rolled adhesive film obtained by laminating simultaneously the above films having the thermosetting resin composition layers of different film thicknesses onto both surfaces of an aramid film ("ARAMICA" manufactured by ASAHI KASEI CORPORATION, both surfaces were plasma-treated) having a thickness of 4.5 µm in such way that the thermosetting resin composition layers of different film thicknesses made contact with the surfaces of the aramid film, respectively, was slit to a width of 507 mm, thereby obtaining an adhesive film sheet having a size of 507 × 336 mm.

The obtained adhesive film had a layer structure in the order of polyethylene terephthalate film (removable supporting film layer)/thermosetting resin composition layer/ polyimide film layer (heat-resistant resin layer)/thermosetting resin composition layer which can be roughened with an oxidizing agent/polyethylene terephthalate film (removable supporting film layer).

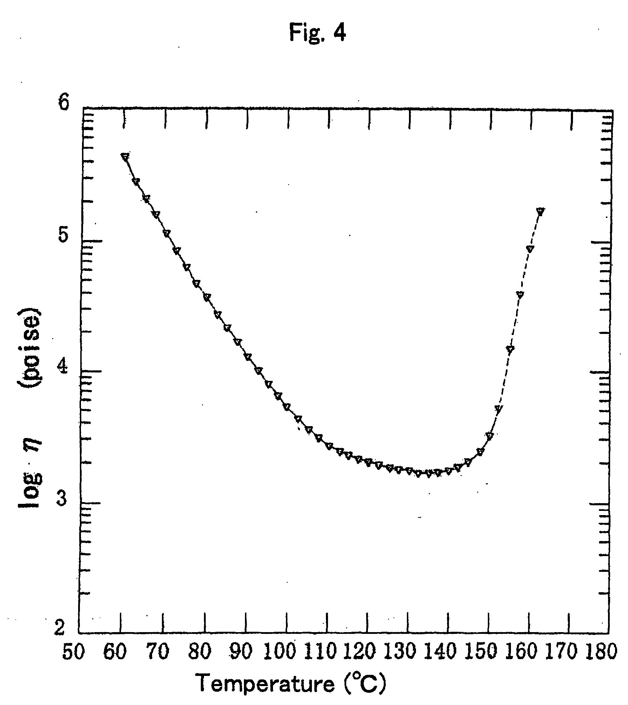

The results of measurement of the moduli of dynamic viscoelasticity of the above-mentioned thermosetting resin composition having a thickness of 45 µm and laminated on a circuit board will be shown in Fig. 4. The measurement was made by use of "Rheosol-G3000" which was the same as that used in Example 1. Measurement conditions were a temperature increasing rate of 5°C/min, a measurement staring temperature of 60°C, a temperature increase between measurements of 2.5°C, and a frequency of 1 Hz/deg. Part of measurement values will be shown in the following Table 5.

| Table 5 | |
|---|---|
| Temperature (C°) | Melt Viscosity (poise) |
| 70 | 116,000 |
| 80 | 37,000 |
| 90 | 13,000 |
| 100 | 5,300 |
| 110 | 2,700 |
| 120 | 2,100 |
| 130 | 1,800 |
| 140 | 1,800 |

### Comparative Example 1

An adhesive film was obtained in the same manner as in Example 1 except that the polyimide film was changed to a polyethylene terephthalate film having a thickness of 38 µm. The adhesive film had a layer structure of polypropylene film/thermo-flowable resin composition/polyethylene terephthalate film.

### Example 5

The polypropylene film of the adhesive film obtained in Example 1 was removed, and the resulting adhesive film was layered on both surfaces of a glass epoxy circuit board (thickness of conductor: 35 µm) having a thickness of 0.4 mm and a size of 510 × 340 mm such that the thermosetting resin composition of the adhesive film made contact with the surfaces of the board. Then, the resulting board was pressed by means of "VACUUM LAMINATOR MVLP" manufactured by MEIKI CO., LTD. at a degree of vacuum of 1 millibar (0.75 mmHg), a temperature of 100°C and a pressure of 6 kg/cm² for 15 seconds so as to laminate both surfaces of the board simultaneously, and the resulting laminated circuit board was then cured by heating at 120°C for 30 minutes and then at 170°C for another 30 minutes. Thereafter, the predetermined through hole and via hole portions were pierced (i.e., through holes and via holes were formed at the relevant parts) by means of a drill and laser, respectively, followed by plasma etching with an oxygen gas, and a conductive layer was formed in the order of nickel, chromium and copper, in accordance with a commonly used method by use of a sputtering device. Then, a plating resist whose pattern was the reverse of the conductive layer was formed, electrolytic copper plating was carried out, and a multilayer printed wiring board was obtained in accordance with a semiadditive process.

Peel strength of the conductor of the obtained multilayer printed wiring board was 0.9 kg/cm. And, the elastic modulus of the insulating layer portion determined by means of a universal hardness meter ("FISCHERSCOPE H100" manufactured by FISCHER INSTRUMENTS CO., LTD.) was 6.7 GPa at room temperature and 5.2 GPa at 150°C.

### Example 6

As in Example 5, the polypropylene film of the adhesive film obtained in Example 2 was removed, and the resulting adhesive film was layered on both surfaces of a glass epoxy circuit board (thickness of conductor: 18 µm) having a thickness of 0.2 mm and a size of 510 × 340 mm such that the thermosetting resin composition of the adhesive film made contact with the surfaces of the board. Then, the resulting board was pressed by means of "VACUUM LAMINATOR MVLP" manufactured by MEIKI CO., LTD. at a degree of vacuum of 1 millibar (0.75 mmHg), a temperature of 100°C and a pressure of 6 kg/cm² for 15 seconds so as to laminate both surfaces of the board simultaneously, and the resulting laminated circuit board was then cured by heating at 120°C for 30 minutes and then at 170°C for another 30 minutes. Thereafter, the polyethylene terephthalate film was removed, followed by forming through holes and via holes at the predetermined parts by means of a drill and laser, respectively. Then, plasma etching with an argon gas was then carried out, and a conductive layer was formed in the order of nickel, chromium and copper, in accordance with a commonly used method by use of a sputtering device. Then, a plating resist whose pattern was the reverse of the conductive layer was formed, electrolytic copper plating was carried out, and a multilayer printed wiring board was obtained in accordance with a semiadditive process.

Peel strength of the conductor of the obtained multilayer printed wiring board after at 170°C for 60 minutes, was 0.9 kg/cm. And, the elastic modulus of the insulating layer portion determined by means of the universal hardness meter was 6.0 GPa at room temperature and 4.6 GPa at 150°C.

### Example 7

As in Example 5, the adhesive film obtained in Example 3 was layered on both surfaces of a glass epoxy circuit board (thickness of conductor: 35 µm) having a thickness of 0.4 mm and a size of 510 × 340 mm such that the thermosetting resin composition of the adhesive film made contact with the surfaces of the board. Then, the resulting board was pressed by means of "VACUUM LAMINATOR MVLP" manufactured by MEIKI CO., LTD. at a degree of vacuum of 1 millibar (0.75 mmHg), a temperature of 100°C and a pressure of 6 kg/cm² for 15 seconds so as to laminate both surfaces of the board simultaneously, and the resulting laminated circuit board was then cured by heating at 120°C for 30 minutes and then at 170°C for another 30 minutes. Thereafter, the polyethlene terephthalate film was removed, through holes and via holes were formed at the relevant parts by means of a drill and laser, respectively, followed by roughening the surface of the thermosetting resin composition layer with an alkaline oxidizing agent of a permanganic acid salt. Then, a plating resist whose pattern was the reverse of the conductive layer was formed, and a multilayer printed wiring board was obtained in accordance with an additive process.

Peel strength of the conductor of the obtained multilayer printed wiring board after annealed at 170°C for 60 minutes, was 1.1 kg/cm. Further, the elastic modulus of the insulating layer portion determined by means of the universal hardness meter was 6.3 GPa at ordinary temperature and 4.8 GPa at 150°C.

### Example 8

As in Example 5, the polypropylene film of the adhesive film obtained in Example 1 was removed, and the resulting adhesive film was layered on both surfaces of a patterned glass epoxy internal layer circuit board (thickness of conductor: 35 µm) having a thickness of 0.4 mm and a size of 10 × 340 mm such that the thermo-flowable resin composition of the adhesive film made contact with the surfaces of the board. Then, the resulting board was pressed by means of "VACUUM LAMINATOR MVLP" manufactured by MEIKI CO., LTD. at a degree of vacuum of 1 millibar (0.75 mmHg), a temperature of 100°C and a pressure of 6 kg/cm² for 15 seconds so as to laminate both surfaces of the board simultaneously, and the resulting laminated circuit board was then cured by heating at 120°C for 30 minutes. Then, a resin varnish of the thermosetting resin composition prepared in Example 3 was roller-coated on both surfaces of the heat-resistant resin film and then cured by heating at 70°C for 20 minutes and then at 150°C for 30 minutes. The thickness of the obtained thermosetting resin composition layer capable of being roughened was 10 µm. Thereafter, through holes and via holes were formed at the predetermined parts by means of a drill and laser, respectively. Then, the surface of the thermosetting resin composition layer capable of being roughened was roughened with an alkaline oxidizing agent of a permanganate, a conductive layer was then formed all over the surface by means of electroless and electrolytic platings, and a multilayer printed wiring board was obtained in accordance with a subtractive process.

Peel strength of the conductor of the obtained multilayer printed wiring board after annealed at 170°C for 60 minutes, was 1.2 kg/cm. And, the elastic modulus of the insulating layer portion determined by means of the universal hardness meter was 6.2 GPa at room temperature, and 4.6 GPa at 150°C.

### Example 9

As in Example 5, the removable supporting base film on the surface of the thermosetting resin composition having a thickness of 45 µm, of the adhesive film obtained in Example 4 was removed, and the resulting adhesive film was layered on both surfaces of a glass epoxy circuit board (thickness of conductor: 35 µm) having a thickness of 0.4 mm and a size of 10 × 340 mm such that the thermosetting resin composition of the adhesive film made contact with the surfaces of the board. Then, the resulting board was pressed by means of "VACUUM LAMINATOR MVLP" manufactured by MEIKI CO., LTD. at a degree of vacuum of 1 millibar (0.75 mmHg), a temperature of 100°C and a pressure of 6 kg/cm² for 15 seconds so as to laminate both surfaces of the board simultaneously, and the resulting laminated circuit board was then cured by heating at 120°C for 30 minutes and at 170°C for another 30 minutes. Then, the polyethylene terephthalate film was removed, and through holes and via holes were formed at the predetermined parts by means of a drill and laser, respectively. Then, the surface of the thermosetting resin composition layer was roughened with an alkaline oxidizing agent of a permanganate, a plating resist whose pattern was the reverse of the conductive layer was formed, and a multilayer printed wiring board was obtained in accordance with an additive process.

Peel strength of the conductor of the obtained multilayer printed wiring board after annealed at 170°C for 60 minutes, was 1.0 kg/cm. And, the elastic modulus of the insulating layer portion determined by means of the universal hardness meter was 5.6 GPa at room temperature, and 4.9 GPa at 150°C.

### Comparative Example 2

The polypropylene film of the adhesive film obtained in Comparative Example 1 was removed, and the resulting adhesive film was layered on both surfaces of a glass epoxy circuit board (thickness of conductor: 35 µm) having a thickness of 0.4 mm and a size of 510 × 340 mm such that the thermosetting resin composition of the adhesive film made contact with both surfaces of the board. Then, the resulting board was pressed by means of "VACUUM PRESSING MACHINE MVLP" manufactured by MEIKI CO., LTD. at a degree of vacuum of 1 millibar, a temperature of 100°C and a pressure of 6 kg/cm² for 15 seconds so as to laminate both surfaces of the board simultaneously. Then, the supporting base film was removed, and the resulting board was then cured by heating at 170°C for 30 minutes. Thereafter, through holes and via holes were formed at the predetermined places by means of a drill and laser, respectively. Then, the surface of the resin composition layer capable of being roughened was roughened with an alkaline oxidizing agent of a permanganate, a conductive layer was then formed all over the surface by means of electroless and electrolytic platings, and a multilayer printed wiring board was obtained in accordance with a subtractive process.

Peel strength of the conductor of the obtained multilayer printed wiring board after annealed at 170°C for 60 minutes, was 1.0 kg/cm. And, the elastic modulus of the insulating layer portion determined by means of the universal hardness meter was 4.8 GPa at room temperature, and 3.1 GPa at 150°C.

### Comparative Example 3

As in Example 1, the resin varnish in Example 1 was coated on a polyimide film ("UPIREX-S" (thickness: 12.5 µm) manufactured by UBE INDUSTRIES, LTD.) both surfaces of which had been subjected to plasma treatment, by means of a die coater such that the thickness of the coated resin would be 60 µm after dried. After the coated resin varnish was dried at 80 to 120°C (100°C on the average) for about 2 minutes (amount of the residual solvent: about 10 wt%), the resulting film was wound up in a roll form while a polypropylene film having a thickness of 15 µm was being laminated onto the surface of the dried thermosetting resin composition. The rolled adhesive film was slit to a width of 507 mm, thereby obtaining an adhesive film sheet having a size of 507 × 336 mm.

The obtained adhesive film had a layer structure in the order of polypropylene film layer (protective film layer)/thermosetting resin composition layer/polyimide film layer (heat-resistant resin layer).

As in Example 5, this adhesive film having a thermosetting resin composition layer was layered on both surfaces of a glass epoxy circuit board (thickness of conductor: 35 µm) having a thickness of 0.4 mm and a size of 510 × 340 mm such that the thermosetting resin composition of the adhesive film made contact with the surfaces of the board. Then, the resulting board was pressed by means of "VACUUM LAMINATOR MVLP" manufactured by MEIKI CO., LTD. at a degree of vacuum of 1 millibar (0.75 mmHg), a temperature of 100°C and a pressure of 6 kg/cm² for 15 seconds so as to laminate both surfaces of the board simultaneously, and the resulting laminated circuit board was then cured by heating at 120°C for 30 minutes and then at 170°C for another 30 minutes.

In this case, however, the thickness of the thermosetting resin composition layer was not uniform, and voids were produced in the thermosetting resin composition, so that a good insulating layer could not be formed.

### Comparative Example 4

As in Example 1, the resin varnish prepared in Example 1 was coated on a polyimide film ("UPIREX-S" (thickness: 12.5 µm) manufactured by UBE INDUSTRIES, LTD.) both surfaces of which had been subjected to plasma treatment, by means of a die coater such that the thickness of the coated resin would be 60 µm after dried. After the coated resin varnish was dried at 80 to 120°C (100°C on the average) for about 15 minutes (residual solvent: about 1 wt% or less), the resulting film was wound up in a roll form while a polypropylene film having a thickness of 15 µm was being laminated onto the surface of the dried thermosetting resin composition. The rolled adhesive film was slit to a width of 507 mm, thereby obtaining an adhesive film sheet having a size of 507 × 336 mm.

The layer structure of the resulting adhesive film was in the order of polypropylene film layer (protective film layer)/thermosetting resin composition layer/polyimide film layer (heat-resistant resin layer).

As in Example 5, this adhesive film having a thermosetting resin composition layer was layered on both surfaces of a glass epoxy circuit board (thickness of conductor: 35 µm) having a thickness of 0.4 mm and a size of 510 × 340 mm such that the thermosetting resin composition of the adhesive film made contact with the surfaces of the board. Then, the resulting board was pressed by means of "VACUUM LAMINATOR MVLP" manufactured by MEIKI CO., LTD. at a degree of vacuum of 1 millibar (0.75 mmHg), a temperature of 100°C and a pressure of 6 kg/cm² for 15 seconds so as to laminate both surfaces of the board simultaneously, and the resulting laminated circuit board was then cured by heating at 120°C for 30 minutes and then at 170°C for another 30 minutes.

In this case, voids were produced between the circuits because of insufficient filling of the thermosetting resin composition therein, so that a good insulating layer could not be formed.

### (Industrial applicability)

According to the present invention, an adhesive film can be obtained which can easily introduce an insulating layer having excellent mechanical strength at the time of producing a multilayer printed wiring board by a build-up technique, and a multilayer printed wiring board having excellent mechanical strength can, in turn, easily be obtained.

## Claims

1. An adhesive film for a multilayer printed wiring board which comprises at least the following Layer A and Layer B in the adjacent position, wherein the thermosetting resin composition constituting the Layer B is a thermosetting resin composition which contains a resin having a lower softening point than the lamination temperature concerned in an amount of not smaller than 10% by weight, and can fill with itself (or resin-fill) the through holes and/or via holes concurrently with being laminated onto a circuit board.
Layer A: A heat-resistant resin layer comprising at least one heat-resistant resin selected from the group consisting of a polyimide, a liquid crystal polymer, an aramid resin and a polyphenylene sulfide and having a thickness of 2 to 30 µm.
Layer B: A thermosetting resin composition layer which contains an epoxy resin having at least two epoxy groups in one molecule (Component (a)) and an epoxy curing agent (Component (b)) and is solid at ordinary temperature.

2. The adhesive film for a multilayer printed wiring board which comprises at least the above-mentioned Layer A and Layer B in the adjacent position as set forth in Claim 1, wherein the said thermosetting resin composition constituting the Layer B is a thermosetting resin composition which contains a resin having a lower softening point than the lamination temperature concerned in an amount of not smaller than 10% by weight, and can resin-fill the through holes and/or via holes concurrently with being laminated onto a circuit board under the lamination conditions of a temperature of 70 to 140°C, a pressure of 1 to 20 kgf/cm² and an air pressure of not higher than 20 mmHg.

3. The adhesive film for a multilayer printed wiring board which comprises at least the above-mentioned Layer A and Layer B in the adjacent position as set forth in Claim 1, wherein the said thermosetting resin composition constituting the Layer B is a thermosetting resin composition which further contains, in addition to Components (a) and (b), a polymer compound having a weight average molecular weight of 5,000 to 100,000 (Component (c)) in an amount of 5 to 50% by weight, contains a resin having a lower softening point than the lamination temperature concerned in an amount of not smaller than 10% by weight, contains component(s) which is/are liquid at ordinary temperature in an amount of 5 to 55% by weight, and can resin-fill the through holes and/or via holes concurrently with being laminated onto a circuit board.

4. The adhesive film for a multilayer printed wiring board which comprises at least the above-mentioned Layer A and Layer B in the adjacent position as set forth in Claim 3, wherein the said thermosetting resin composition constituting the Layer B is a thermosetting resin composition which further contains, in addition to Components (a) and (b), a polymer compound having a weight average molecular weight of 5,000 to 100,000 (Component (c)) in an amount of 5 to 50% by weight, contains a resin having a lower softening point than the lamination temperature concerned in an amount of not smaller than 10% by weight, contains component(s) which is/are liquid at ordinary temperature in an amount of 5 to 55% by weight, and can resin-fill the through holes and/or via holes concurrently with being laminated onto a circuit board under the lamination conditions of a temperature of 70 to 140°C, a pressure of 1 to 20 kgf/cm² and an air pressure of not higher than 20 mmHg.

5. The adhesive film for a multilayer printed wiring board which comprises at least the above-mentioned Layer A and Layer B in the adjacent position as set forth in Claim 1, wherein the said thermosetting resin composition constituting the Layer B is a thermosetting resin composition which shows a melt viscosity of 4,000 to 50,000 poises at 90°C, 2,000 to 21,000 poises at 100°C, 900 to 12,000 poises at 110°C, 500 to 9,000 poises at 120°C, and 300 to 15, 000 poises at 130°C, when heated with a measurement starting temperature of 60°C and a temperature increasing rate of 5°C/min.

6. The adhesive film for a multilayer printed wiring board as set forth in any one of Claims 1 to 5, wherein the said heat-resistant resin layer (Layer A) and the said thermosetting resin composition layer (Layer B) are formed above a removable supporting film layer (Layer C) , and in the layer structure in the order of Layer B, Layer A and Layer C (i.e., wherein a heat-resistant resin layer (Layer A) is formed on a removable supporting film layer (Layer C), and a thermosetting resin composition layer (Layer B) is formed on the Layer A).

7. The adhesive film for a multilayer printed wiring board as set forth in any one of Claims 1 to 5, wherein the said heat-resistant resin layer (Layer A) and the said thermosetting resin composition layer (Layer B) are formed above a removable supporting film layer (Layer C), and in the layer structure in the order of Layer A, Layer B, and Layer C.

8. The adhesive film for a multilayer printed wiring board as set forth in any one of Claims 1 to 5, wherein the said heat-resistant resin layer (Layer A) and the said thermosetting resin composition layer (Layer B) are formed above a removable supporting film layer (Layer C) , and in the layer structure in the order of Layer B, Layer A, Layer B and Layer C, (i.e., wherein a thermosetting resin composition layer (Layer B) is formed on a removable supporting film layer (Layer C), a heat-resistant resin layer (Layer A) is then formed on the formed Layer B, and another thermosetting resin composition layer (Layer B) is then formed on the formed Layer A); and at least the Layer B which is adjacent to the Layer C can be roughened by means of an oxidizing agent.

9. The adhesive film for a multilayer printed wiring board as set forth in Claim 6 or 8, wherein the surface of the said thermosetting resin composition layer (Layer B) which surface is not adjacent to the Layer A is covered with a protective film layer (Layer D) or a removable supporting film layer (Layer C).

10. A multilayer printed wiring board produced with the use of the adhesive film for a multilayer printed wiring board as set forth in any one of Claims 1 to 9.

11. A method for producing a multilayer printed wiring board, which method comprises the following steps of (i) to (viii):
(i) a step of laminating the adhesive film as set forth in any one of Claims 1 to 9 on one or both surfaces of a circuit board with the thermosetting resin composition layer (Layer B) being made to face the circuit board, after a protective film layer (Layer D) or a removable supporting film layer (Layer C) has been removed when the Layer B which is positioned in such that it is in contact with the circuit board upon lamination is covered with the Layer C or D,
(ii) a step of removing the removable supporting film layer (Layer C) as required when the Layer C is present,
(iii) a step of thermosetting the thermosetting resin composition layer (Layer B) of the adhesive film laminated on the circuit board so as to form an insulating layer,
(iv) a step of removing the removable supporting film layer (layer C) when the Layer C is present,
(v) a step of piercing the circuit board having the insulating layer formed thereon,
(vi) a step of roughening the surface of the insulating layer,
(vii) a step of forming a conductive layer on the roughened surface of the insulating layer by plating, and
(viii) a step of forming a circuit on the conductive layer.
